# EUROPEAN PATENT SPECIFICATION

(11) **EP 0 921 401 B1**
(45) Date of publication and mention of the grant of the patent: **03.03.2004**
(21) Application number: 97121526.4
(22) Date of filing: 06.12.1997
(51) Int. Cl.: G01R 1/073

(54) **Probe and method for inspection of electronic circuit board**
Sonde und Verfahren zur Prüfung einer elektrischen Leiterplatte
Sonde et procédé pour l'inspection d'un circuit imprimé électronique

(43) Date of publication of application: 09.06.1999
(73) Proprietor: SHIN-ETSU POLYMER CO., LTD., Tokyo (JP)
(72) Inventor: Yamazaki, Kouichi, Matsumoto-shi, Nagano-ken (JP); Komatsu, Hiroto, Omiya-shi, Saitama-ken (JP)
(74) Representative: Luderschmidt, Schüler & Partner GbR

(56) References cited:
- PATENT ABSTRACTS OF JAPAN vol. 008, no. 001 (P-246), 6 January 1984 & JP 58 165056 A (NIHON DENSHI ZAIRIYOU KK), 30 September 1983,
- PATENT ABSTRACTS OF JAPAN vol. 008, no. 088 (E-240), 21 April 1984 & JP 59 009935 A (NIHON DENSHI ZAIRIYOU KK), 19 January 1984,
- PATENT ABSTRACTS OF JAPAN vol. 008, no. 008 (E-221), 13 January 1984 & JP 58 173841 A (NIHON DENSHI ZAIRIYOU KK), 12 October 1983,
- PATENT ABSTRACTS OF JAPAN vol. 012, no. 489 (E-696), 21 December 1988 & JP 63 202929 A (TOKYO ELECTRON LTD), 22 August 1988,
- PATENT ABSTRACTS OF JAPAN vol. 095, no. 001, 28 February 1995 & JP 06 300782 A (TOKYO ELECTRON LTD;OTHERS: 01), 28 October 1994,
- PATENT ABSTRACTS OF JAPAN vol. 018, no. 519 (P-1807), 29 September 1994 & JP 06 180329 A (DATA PUROOBU:KK), 28 June 1994,
- PATENT ABSTRACTS OF JAPAN vol. 096, no. 005, 31 May 1996 & JP 08 005663 A (AGING TESUTA KAIHATSU KYODO KUMIAI), 12 January 1996,
- PATENT ABSTRACTS OF JAPAN vol. 013, no. 525 (E-850), 22 November 1989 & JP 01 214038 A (MITSUBISHI ELECTRIC CORP), 28 August 1989,

## Description

### BACKGROUND OF THE INVENTION

The present invention relates to a probe and a method for inspection of an electronic circuit board such as IC package substrates used in mounting of chip-formed semiconductor devices and semiconductor silicon wafers by electrical tests; (see e.g. JP-A-58 165 056).

Along with the remarkable trend in the manufacture of electronic instruments toward a more and more compact designs, higher and higher density of integration or mounting density of devices, higher and higher fineness and higher and higher performance required thereof and so on, various kinds of innovative technologies are widely and extensively employed therefor although some of these modern leading technologies are sometimes still on the way of development of the production process so that it is almost always indispensable to have the intermediate assemblies of the products to be subjected to various tests for inspection at each of the process steps.

When a semiconductor device having an increased density of integration, fineness and upgraded performance is to be mounted on an electronic circuit board, it is a requirement of consequence for the circuit board that the number of the electrode terminals thereon for electrical connection with the terminals of the semiconductor devices must be increased accordingly along with a decrease in the arrangement pitch of the electrodes.

With an object to comply with the very strong demand for electronic instruments of increased compactness, development works are now under way to replace the mounting fashion by using conventional semiconductor packages with the so-called flip-chip mounting, in which semiconductor devices are mounted on a circuit board in the form of chips, and multi-chip module mounting in which a plural number of semiconductor devices are simultaneously mounted on the circuit board. These mounting technologies are expected to contribute not only to enabling of a more compact design of the electronic instruments but also to upgrading of the performance of the electronic instruments.

Furthermore, the circuit wiring of a circuit board on which semiconductor chips are mounted is made by using finer and finer wires or filaments along with an increase in the wiring density so that the inspection techniques also must accord with this trend in the wiring. An inspection probe of one type for inspection of such electronic circuit boards is provided with a number of pins made from a hard metal such as tungsten and arranged to correspond to the number and arrangement pitch of the electrodes on the circuit board under inspection. Preparation of such an inspection probe is heretofore conducted in a very fine manual work in which the end point of each of the tungsten pins is sharpened by etching and the thus sharpened tungsten pins are fixed to the probe base under a microscope in an arrangement to correspond to the number and pitch of the electrodes on the circuit boards under inspection. This extremely fine microscopic work for the preparation of inspection probes involving a large number of pins is so laborious and time-consuming that a great increase in the production costs therefor is unavoidable. Needless to say, such an inspection probe can be used specifically for inspection of only one type of the circuit boards and each type of the circuit boards to be inspected requires a specifically designed inspection probe.

In addition to the above mentioned high costs, these inspection probes with tungsten pins are not always suitable for high-speed inspection of semiconductor devices because each of the tungsten pins has a relatively large length of, for example, about 50 mm from the pin point to the end reaching the connecting part of the circuit board. Moreover, the inspection with such an inspection probe is conducted by means of measurements for pin by pin successively and a single inspection test can be completed only with a number of measurements taking a long time. No appropriate connecting technology has been established heretofore to fully comply with modern circuit boards having fine electrodes arranged in a high density or with a fine pitch.

As is understood from the above given description, development of a high-performance inspection probe and inspection technology is an urgent necessity in order to comply with the rapid progress in the modern manufacturing technology of circuit boards and mounting technology of semiconductor devices. The requirement in this regard is not limited to the inspection technology to accord with the flip-chip mounting and multi-chip module mounting as a matter of course but also includes the inspection technology of semiconductor devices in the form of a chip *per se* or wafer. Despite the so great efforts for the development of inspection probes and method for inspection of electronic circuit boards, the inspection probes heretofore proposed are not free from several problems in connection with the fineness in the arrangement pitch of electrodes and in the high-speed signal transmission so that appearance of more improved inspection probes and methods for inspection of electronic circuit boards are eagerly desired.

### SUMMARY OF THE INVENTION

The present invention accordingly has an object, in view of the above described problems and disadvantages in the prior art, to provide a novel and improved probe for inspection of electronic circuit boards capable of being prepared at an outstandingly low cost as well as a method for inspection thereof capable of ensuring high-speed inspection even for an electronic circuit board provided with a great number of electrodes arranged in an extremely fine pitch.

Thus, the inspection probe for an electronic circuit board provided by the present invention is an assembly which comprises:
(a) a base plate having an opening made from an electrically insulating plastic resin;
(b1) a first group of electrodes fixed and arranged on the base plate in the vicinity of the periphery of the opening;
(b2) a second group of electrodes fixed and arranged on the base plate in the vicinity of the marginal periphery of the base plate, the first group of electrodes and the second group of electrodes being electrically connected to form an electric circuit;
(c) connecting lead wires each connected at one end to one of the first group of electrodes, the other end being extended downwardly through the opening in the base plate;
(d) an encapsulation molded from an insulating elastomeric polymer having flexibility to embed the connecting lead wires as a whole, the downwardly extended end of each of the connecting lead wires being exposed out of the encapsulation to face downwardly in such a fashion as to be capable of being contacted with one of the electrodes on an electronic circuit board under inspection; and
(e) a reinforcement molded from a rigid material to cover the encapsulation.

The present invention further provides a novel method for inspection of an electronic circuit board by using the above defined inspection probe in such a manner as to comprise the steps of:
i) bringing into contact the exposed end of each of the connecting lead wires with one of the electrodes of a first group on the electronic circuit board under inspection;
ii) electrically connecting each of the electrodes of a second group on the electronic circuit board under inspection with one of the electrodes on a first base board of an inspection instrument either directly or with intervention of an elastic connector; and
iii) electrically connecting each of the electrodes on a second base board of the inspection instrument, which are in connection by wiring with the first base board of the inspection instrument, with one of the second group of electrodes of the inspection probe with intervention of an elastic connector.

### BRIEF DESCRIPTION OF THE DRAWING

Figure 1 is a vertical cross sectional view of the inventive inspection probe as a basic embodiment.
Figures 2A to 2D are each an illustration of one of the successive steps in the preparation of an inventive inspection probe by a vertical cross section thereof.
Figure 3 is a vertical cross sectional view of another embodiment of the inventive inspection probe in which the base plate has a stratified structure with stepped level differences of the surface around the opening and the first group electrodes are provided on the stepped surface.
Figure 4 is a vertical cross sectional view of another embodiment of the inventive inspection probe adaptable to an electronic circuit board for inspection having a stepped surface.
Figure 5 is a vertical cross sectional view of the inventive inspection probe of a still different embodiment in which the rigid reinforcement has a view hole to ensure exact mounting of the inspection probe on an electronic circuit board under inspection.
Figures 7A and 7B are each an illustration of the connection between an electronic circuit board and an inspection instrument in an embodiment by a vertical cross sectional view.
Figure 8 is an illustration of the connection between an electronic circuit board and an inspection instrument in another embodiment by a vertical cross sectional view.
Figure 9 is an illustration of the connection between an electronic circuit board and an inspection instrument in a further different embodiment by a vertical cross sectional view.

### DETAILED DESCRIPTION OF THE PREFERRED EMBODIMENTS

In the above defined inspection probe of the invention, the base plate of the probe is provided with groups of electrode terminals each at a position corresponding to one of the electrode terminals on the electronic circuit board under inspection, which is referred to simply as the board for inspection hereinafter. The base plate of the inspection probe has at least one opening and the electrode terminals of a first group are positioned in the vicinity of or around the periphery of this opening while the electrode terminals of a second group are positioned in the vicinity of or along the marginal periphery of the base plate. Each of the electrode terminals in the first group is electrically connected by wiring running, for example, in the radial direction to one of the electrode terminals in the second group. It is sometimes advantageous when the arrangement pitch of the electrode terminals in the board for inspection is very fine to use a pitch-conversion base plate by which the second group electrodes of the base plate may have a pitch converged to comply with the electrode pitch on the board for inspection. A plurality of connecting lead wires are provided, each of which is bonded at one end to one of the electrode terminals of the first group and has a contacting terminal at the other end. The arrangement pitch of the electrode terminals in the second group can be the same as that in the first group. It is advantageous when the electrode terminals of the board for inspection are arranged with a fine pitch not exceeding 0.5 mm or in the range from 0.2 to 0.5 mm, however, that an appropriate modification is effected in the arrangement pitch of the electrode terminals of the second group. When the inspection probe of the invention is to be used in the inspection of boards for inspection of the area-array type, it is preferable that the base plate of the inspection probe is made of a multilayered laminated plate,

Each of the connecting lead wires is made from a fine metal filament and bonded at one end to one of the electrode terminals of the first group on the base plate by the method of wire bonding while the other end thereof extends downwardly through the opening of the base plate. The metallic material forming the metal filament for the connecting lead wires can be selected from metals and alloys susceptible to wire bonding such as gold, gold-based alloys, copper, aluminum, aluminum-silicon alloys, beryllium copper, brass, nickel, molybdenum, tungsten and stainless steels though not particularly limitative thereto. It is advantageous that non-gold metal filaments are plated with gold or a gold-based alloy to be imparted with corrosion resistance although gold filaments are the most preferable if not for the expensiveness thereof. The diameter of the metal filament is selected in accordance with the arrangement pitch of the electrode terminals on the board for inspection and the metallic material thereof but it is in the range, usually, from 18 to 50 µm or, preferably, from 25 to 30 µm when the filament is of gold.

The end of the connecting lead wire extended downwardly through the opening of the base plate is provided with a semispherical contacting point which is preferably plated with gold in order to minimize contact resistance when the contact point is brought into contact with the electrode terminal on the board for inspection.

The assembly of the connecting lead wires extended downwardly each from one of the electrode terminals of the first group on the base plate through the opening thereof is, as a whole, embedded in an encapsulation of an electrically insulating elastic material having flexibility excepting the above mentioned contact points at the respective ends opposite to the electrode terminals. The above mentioned elastic material can be selected from various kinds of rubbery materials including silicone rubbers, epoxy rubbers, urethane rubbers and other synthetic rubbers. The elastic encapsulation serves to impart the connecting lead wires with resilience so as to ensure an adequate contacting pressure between the contact point of the connecting lead wire and the electrode terminal on the board for inspection by elastically conforming with deformation of the connecting lead wires. The elastic encapsulation is covered with a rigid reinforcement molded from a rigid material such as general-purpose engineering plastic resins, ceramics and metals by taking into account the heat resistance, dimensional stability and molding workability of the material.

As compared with conventional inspection probes, the inspection probe of the present invention having the above described structure has an advantage of enabling high-speed inspection of boards for inspection as a consequence of the greatly decreased connecting distance rarely exceeding 5 mm in addition to the advantage of adaptability to a board for inspection having electrode terminals arranged at a very fine pitch. In particular, the inventive inspection probe formed by using a multi-layered plate as the base plate is suitable for inspection of a board for inspection having a great number of electrode terminals arranged, for example, in a matrix arrangement so as to comply with the trend toward an increasingly large number of electrode terminals.

Further, since the contacting points are provided at a level lower than the lower surface of the base plate of the probe and the connecting lead wires are as a whole encapsulated with an elastic rubbery material, high reliability can be ensured in the contacting condition between the contacting points of the connecting lead wires and the electrode terminals on the board for inspection without being affected by warp and undulation of the board for inspection by virtue of the elastic resilience given to the contact points.

In an alternative aspect of the invention, a novel method is provided for the inspection of an electronic circuit board by using the above described inspection probe. Thus, the method of the invention comprises the steps of:
i) bringing into contact the exposed end of each of the connecting lead wires with one of the electrodes of a first group on the electronic circuit board under inspection;
ii) electrically connecting each of a second group electrodes on the electronic circuit board under inspection with one of the electrodes on a first base board of an inspection instrument either directly or with intervention of an elastic connector; and
iii) electrically connecting each of the electrodes on a second base board of the inspection instrument, which are in connection by wiring with the first base board of the inspection instrument, with one of the second group of electrodes of the inspection probe with intervention of an elastic connector.

In step ii) of the above described method, it is an alternative way that connection is made between the electrodes on a first base board of an inspection instrument provided with a plurality of pogo pins and the second group electrodes on the electronic circuit board under inspection.

In the inspection method of the present invention by using an inspection probe described above having connecting lead wires extended through the opening in the base plate of the inspection probe from the first group electrodes in the vicinity of or around the periphery of the base plate and embedded in an elastic encapsulation, elastic connectors are employed through which electric connection is established between the contact points of the connecting lead wires and the first group electrodes of the board for inspection and between the second group electrodes of the board for inspection and the electrodes on the first base board of the inspection instrument along with direct connection of the electrodes on the first base board of the inspection instrument as formed with a plurality of pogo pins and connection through an elastic connector between the second group electrodes of the inspection probe and the electrodes on the second base board of the inspection instrument. Since these connections are established with elastic resilience under compression, reliability of electric connection is ensured by applying a slight compressive force thereto. By virtue of the greatly decreased connecting length, in addition, electric connection can be established at a high speed and with reliability even when the electrodes on the board for inspection are arranged in a high density.

In conducting inspection of a board for inspection having extremely fine electrodes arranged in a high density or, for example, in the inspection of a board for inspection of which the substrate is made of a multi-layered plate having a recess and electrodes are provided on the respective stepped areas of the respective layers around the recess or, namely, an IC package board, the inspection can be performed by using an inspection probe in which the first group electrodes are provided around the opening of the base plate as protruded in a cross-stitch or zigzag arrangement to comply with the arrangement of the electrodes on the stepped areas of the board for inspection.

Alternatively, the inspection probe can be formed with a multi-layered base plate having stepped areas around the opening with connecting lead wires bonded at the respective stepped areas.

In conducting inspection of an electronic circuit board according to the inventive method, firstly, the board for inspection is mounted on the electrodes on the first base board of the inspection instrument in such a fashion that the second group electrodes of the board for inspection are brought into electric connection with the electrodes on the first base board of the inspection instrument. In this case, an elastic connector can be interposed between two groups of electrodes. When the arrangement pitch of the second group electrodes on the board for inspection is relatively large, for example, to be 0.5 mm or larger, though with a small pitch of the second group electrodes in the range from 0.18 to 0.20 mm, a plurality of pogo pins are provided in the electrodes on the first base board of the inspection instrument, which are brought into direct connection with the second group electrodes of the board for inspection.

In the next place, the first group electrodes of the board for inspection are connected to the first group electrodes on the base plate of the inspection probe by means of the connecting lead wires and further the second group electrodes on the lower surface of the base plate of the inspection probe are connected to the electrodes on the second base board of the inspection instrument with intervention of an elastic connector, anisotropic electroconductive sheet or a plastic sheet having metallic contacting points in the form of bumps so as to establish an electric circuit for inspection.

Of the above mentioned elastic connectors, anisotropic electroconductive sheets and plastic sheets with metallic contacting bumps, elastic connectors are preferred because the other means are not adaptable with reliability to a small pitch of 0.5 mm or smaller in the arrangement of the electrode terminals. Elastic connectors are available as a commercial product including connectors of type MT (products by Shin-Etsu Polymer Co.) having a multiplicity of fine metal filaments embedded in parallel with a specific inclination angle within an insulating matrix sheet of a rubbery elastomer.

In the following, several different embodiments of the inventive inspection probe and method for inspection thereof are described in more detail by way of examples making reference to the accompanying drawings each showing the inspection probe by a vertical cross sectional view.

### Example 1.

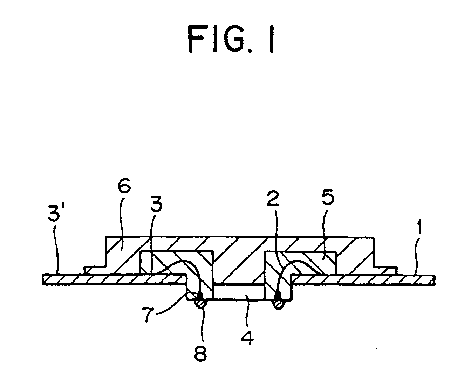

As is illustrated in Figure 1 by a vertical cross sectional view, the inspection probe prepared in this Example was a basic embodiment of the invention and had a base plate 1 made from an insulating material such as a plastic resin and having an opening 4 at about the center thereof. A plurality of connecting lead wires 2 were bonded each at one end to one of the first group electrodes 3 on the base plate 1 in the vicinity of or around the center opening 4. A second group electrodes 3' were provided on the base plate 1 in the vicinity of or along the marginal peripheries of the base plate 1, each of the second group electrodes 3' being electrically connected to one of the first group electrodes 3. Each of the connecting lead wires 2 was downwardly extended through the center opening 4 while the connecting lead wires 2 as a whole were embedded in an encapsulation 5 made from an electrically insulating elastic material such as a rubber excepting the other end points 7 which were exposed out of the elastic encapsulation 5 to face downwardly. The end point 7 was provided with a semispherical contact point 8 and plated with gold to ensure high reliability of electric contact therewith. The elastic encapsulation 5 was entirely covered with a rigid reinforcement 6 to serve as a protective means.

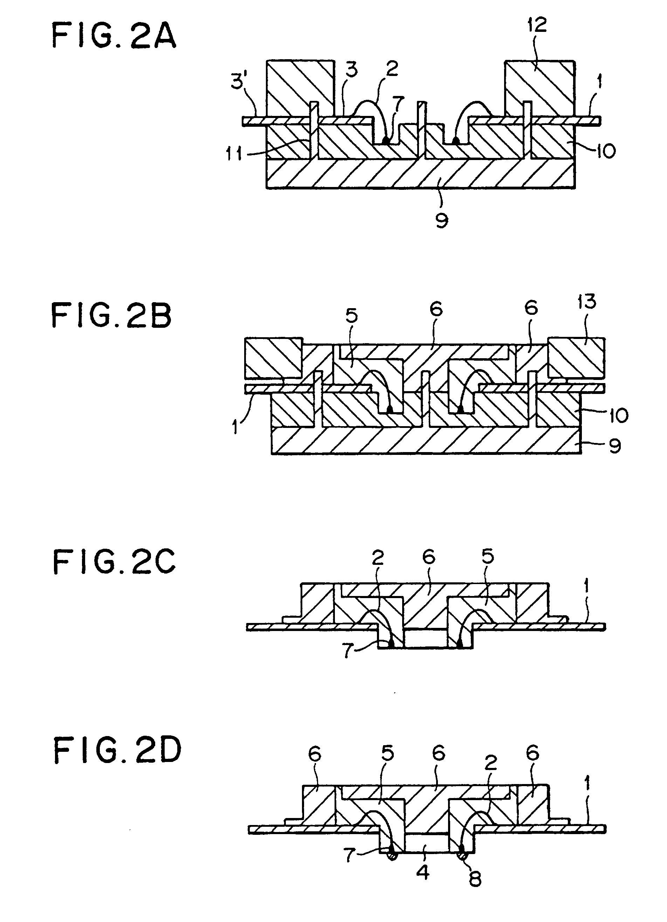

Figures 2A to 2D are each for illustration of one of the manufacturing steps in sequence for the preparation of the inspection probe as described above.

In the first place, as is illustrated in Figure 2A, a copper spacer 10 having a thickness of about 0.5 mm was mounted on an alignment jig plate 9 at an exact position by means of the locating pins 11. The copper spacer 10 had engraved pits of 0.3 mm depth at positions corresponding to the electrode arrangement in the board for inspection so as to serve as the areas for the first and second groups of electrodes 3, 3' in the inspection probe. The surfaces of the engraved pits were plated with gold. A base plate 1 was mounted on the copper spacer 10 with exact positioning by means of the locating pins 11. Further, a securing plate 12 was overlaid on the base plate 1 so as to secure the whole assembly.

The base plate 1 having a center opening was provided with first group electrodes 3 around the center opening and with second group electrodes 3' along th outere peripheries of the base plate 1 patterned in the same arrangement and pitch as the electrode terminals of the board for inspection.

A gold filament of 25 µm diameter was bonded by the method of wire bonding to the gold-plated surface of each of the engraved pits in the copper spacer 10 to serve as the connecting lead wire 2 at the position corresponding to one of the electrode terminals on the board for inspection and the other end of each of the connecting lead wires 2 was bonded to one of the first group electrodes 3 on the base plate 1. This bonding work at both ends of each of the connecting lead wires 2 was repeated as many times as the number of the electrode terminals on the board for inspection. After completion of this bonding work, the securing plate 12 was removed.

In the next place, as is illustrated in Figure 2B, a molded reinforcement 6 was mounted on the base plate 1 and the whole assembly was secured by mounting another securing plate 13. The reinforcement 6 was provided with a port (not shown in the figure) for injection of an uncured flowable elastomer for encapsulation and an uncured urethane resin was injected through the port in the reinforcement 6 into the cavity between the reinforcement 6 and the base plate 1. The uncured urethane resin was cured by keeping at room temperature for 24 hours followed by aging at 60 °C for 2 hours to complete an encapsulation 5 of a cured urethane rubber. The base plate 1 and the reinforcement 6 were integrally bonded together by adhesion to the encapsulation 5 of the cured urethane rubber. The reinforcement 6 was formed from a polyphenylene sulfide resin as a rigid plastic resin having excellent electric properties.

The step to follow was etching of the copper spacer 10. Thus, after the base plate 1 and the rigid reinforcement 6 are firmly bonded together by adhesion, the securing plate 13 and the alignment jig plate 9 were removed and the copper spacer 10 was dissolved away by etching with an aqueous solution of iron (III) chloride in an appropriate concentration so that the end portions 7 of the respective connecting lead wires 2 became exposed coplanarly at the bottom surface of the elastic encapsulation 5 as is illustrated in Figure 2C while the connecting lead wires 2 as a whole were secured as embedded in the encapsulation 5.

Since the end portions 7 coplanarly exposed at the bottom surface of the elastic encapsulation 5 could not establish any reliable contacting condition when the above obtained assembly was laid on the electrode terminals of a board for inspection, each of the end points 7 of the connecting lead wires 2 was provided with a semispherical contact point 8 of about 40 µm height with a hard gold-plating layer having a thickness of about 3 µm, as is illustrated in Figure 2D, so as to improve wearing resistance of the contact points 8.

The description given above is merely to show an example of the manufacturing steps of the inventive inspection probes and, needless to say, various modifications are possible thereto depending on the particular design of the probe and materials of the respective parts.

### Example 2.

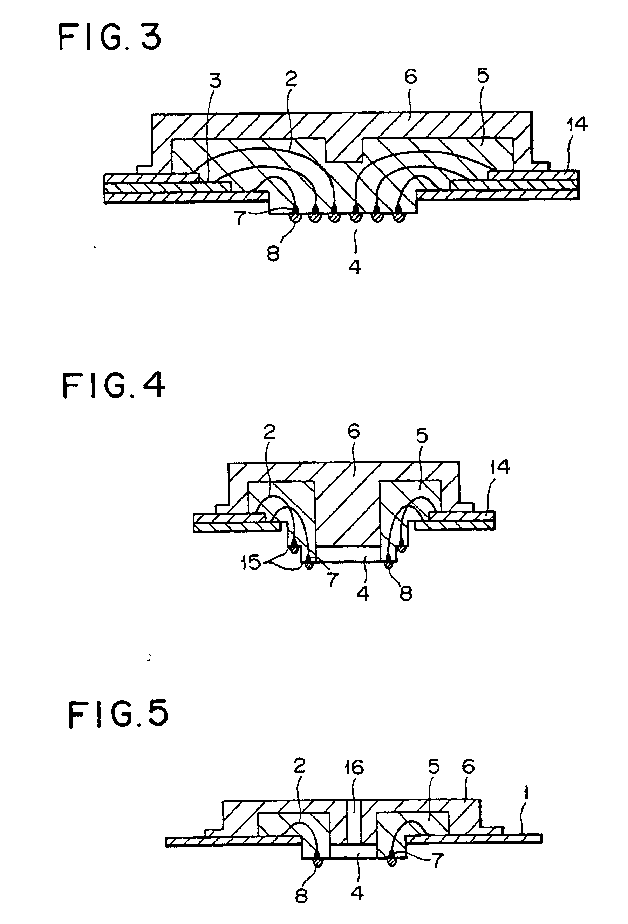

The inspection probe prepared in this Example is illustrated in Figure 3 by a vertical cross sectional view. In this embodiment, a three-layered plate 14 was used in place of the base plate 1 made of a single plate described in Example 1. The base plate 14 had stepped level differences around the center opening 4 with stepped areas stepping down toward the center opening 4. The connecting lead wires 2 were subdivided into three subgroups and the lead wires 2 of each of the subgroups were bonded by wire bonding to one of the first group electrodes 3 on one of the stepped areas of the base plate 14 around the center opening 4.

The first group electrodes 3 on the lower, middle and upper stepped areas were pattern-arranged in a cross-stitch or zigzag arrangement relative to the adjacent subgroup of the electrodes 3 so that the wire bonding work could be successfully performed even though each electrode had a width smaller than 100 µm as is usually required for wire bonding so that the arrangement pitch of the contact points 8 on the bottom surface of the elastic encapsulation 5 could be so fine accordingly.

Though not described here, the above described inspection probe of a modified embodiment could be prepared in substantially the same procedure as in Example 1 excepting for the use of a multi-layered base plate 14 in place of the single-layered base plate 1 in Example 1.

### Example 3.

The inspection probe prepared in this Example is illustrated in Figure 4 by a vertical cross sectional view. In this embodiment, the bottom surface of the elastic encapsulation 5 had stepped level differences to form stepped ring areas 15 around the center opening 4 of the base plate 14 which was a bilayered laminate having stepped ring areas around the center opening 4. Accordingly, the connecting lead wires 2 were divided into two groups so that each of the lead wires 3 of one of the groups was bonded to the electrode 3 on one of the stepped ring areas of the base plate 14 at one end while the other end was exposed at one of the stepped ring areas 15 on the bottom surface of the encapsulation 5 and each of the connecting lead wires 2 of the other group was bonded to the electrode 3 on the other stepped ring area of the base plate 14 at one end while the other end thereof was exposed at the other stepped ring area 15 on the bottom surface of the encapsulation 5.

This model of the inventive inspection probe had adaptability to the inspection of a board for inspection having electrode terminals both on the bottom and around a recess or cavity.

### Example 4.

The inspection probe prepared in this Example is illustrated in Figure 5 by a vertical cross sectional view. This embodiment was a simple modification of the embodiment in Example 1, in which the rigid reinforcement 6 was provided with a view hole 16 through which the board for inspection below the inspection probe could be viewed so that the inspection probe could be very exactly and accurately mounted on the board for inspection.

Although it is preferable in most cases that the positioning view hole 16 is formed at about the center of the opening 4 in the base plate 1 as is illustrated in Figure 5, the position of the view hole 16 is not particularly limitative provided that no interference or disturbance is caused with circuit wiring and electric connection.

### Example 5.

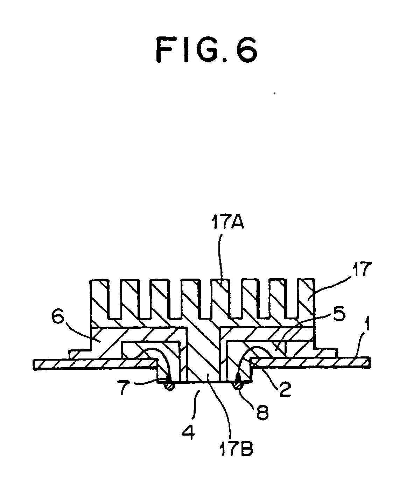

The inspection probe prepared in this Example is illustrated in Figure 6 by a vertical cross sectional view. The inspection probe per se of this embodiment was substantially the same as in Example 1 but a finned heat dissipater 17 is mounted on top of the rigid reinforcement 6 in direct contact therewith to greatly improve the efficiency of heat dissipation so that the inspection with the inspection probe could be performed safely even when the board for inspection was heat-generating under the inspection works. The heat dissipater 17 is provided with a large number of fins 17A on the upper surface so as to greatly increase the surface areas available for heat dissipation. In addition, the heat dissipater 17 is provided with a downwardly extending center boss 17B which is inserted into and penetrates the opening 4 formed in the rigid reinforcement 5 so that the surface area of the heat dissipater 17 is increased so much.

The material from which the heat dissipater 17 is formed is not particularly limitative provided that the material has a high heat conductivity and good workability in shaping. In this regard, aluminum was used in this Example for the heat dissipater 17.

### Example 6.

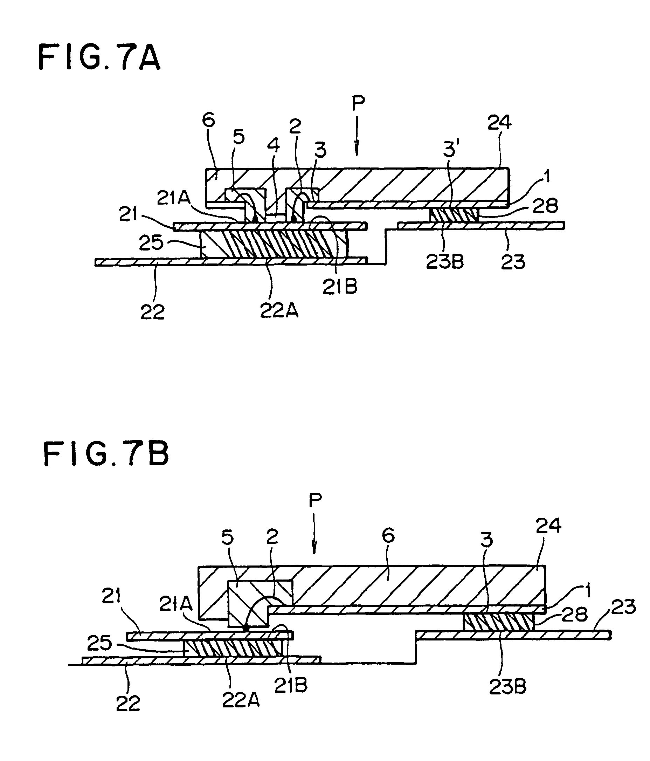

Figures 7A and 7B each illustrate the testing procedure for inspection of an electronic circuit board 21 having a generally flat configuration such as an IC substrate, semiconductor wafer and the like as the board for inspection according to the inventive method. Namely, each of Figures 7A and 7B is a vertical cross sectional view of an assembly consisting of the board for inspection 21, the first and second base boards 22, 23 of an inspection instrument (not shown in the figures) and the inspection probe 24 in electrical connection. In the embodiment illustrated in Figure 7A, the first group of electrodes 3 of the inspection probe 24 were provided in the vicinity of the opening 4 of the base plate thereof while, in the embodiment illustrated in Figure 7B, the first group of electrodes 3 of the inspection probe 24 were provided in the vicinity of the periphery of the base plate 1 thereof.

In the first place, an elastic connector 25 was mounted on the electrodes 22A of the first base board 22 of the inspection instrument and the board for inspection 21 was further laid thereon in such a fashion that the second group of electrodes 21B of the board for inspection 21 were brought into electrical connection with the first base board 22 of the inspection instrument through the elastic connector 25.

In the next place, the inspection probe 24 was moved to a position close to the board for inspection 21 so as to establish electrical connection between the end portions of the connecting lead wires 2 bonded to the first group of electrodes 3 of the inspection probe 24. Further, an elastomer connector 28 (Type MT, a product by Shin-Etsu Polymer Co.) was mounted on the electrodes 23B of the second base board 23 of the inspection instrument so that electrical connection was established between the second group of electrodes 3' of the inspection probe 24 and the electrodes 23B of the base board 23 through the elastic connector 28 interposed therebetween to complete the inspection circuit.

Inspection of the board for inspection 21 was conducted by applying a vertical force in the direction indicated by the arrow P onto the inspection probe 24 mounted on the board for inspection 21, of which the electrode terminals of the first and second groups were arranged with a pitch of 200 µm, so that very reliable electrical connection could be obtained with each of the electrodes to perform the electrical inspection of the board for inspection 21 very reliably and very rapidly.

### Example 7.

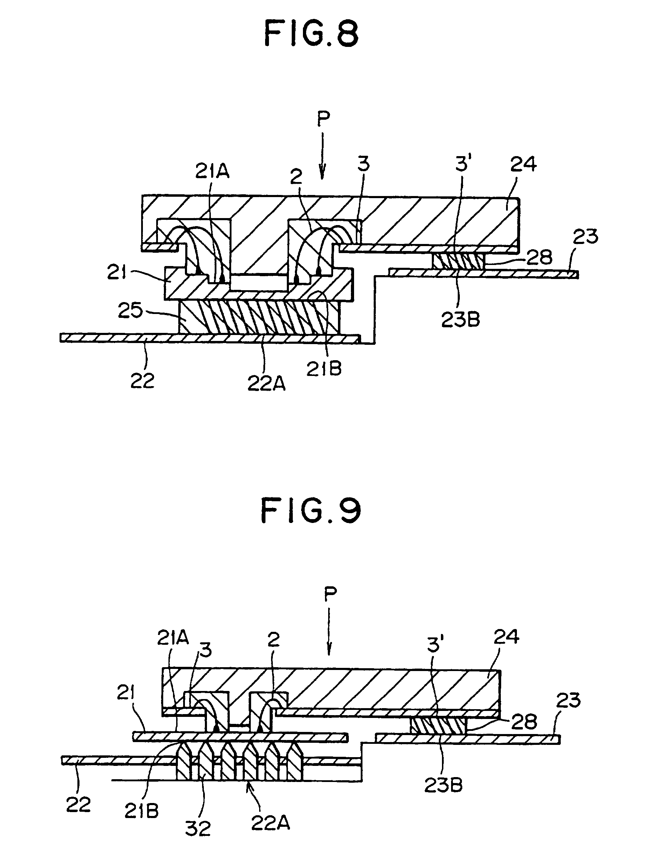

Figure 8 illustrates another embodiment of the inventive method for the inspection of a board for inspection 21, of which the first group electrodes 21A are formed on the stepped areas of the board 21 as is sometimes the case in IC package boards, the method in other respects being identical with that described in Example 6.

By applying a pressing force in the vertical direction indicated by the arrow P onto the inspection probe 24, electrical inspection of the board for inspection 21 could be performed very reliably and very rapidly.

### Example 8.

This Example is for an embodiment in which, as is illustrated in Figure 9 by a vertical cross sectional view, the electrodes 22A of the first base board 22 of the inspection instrument (not shown in the figure) and the second group of electrodes 21B of the board for inspection 21 are directly connected, instead of using a elastic connecter 25 used in Examples 6 and 7, by means of an electrode assembly 22A provided with a plurality of gold-plated pogo pins 32 each having a diameter of 0.5 mm. The method is identical in other respects with the methods described in Examples 6 and 7. By virtue of the spring means of the pogo pins 32, the electrode groups could be contacted with each other with resilience to establish electrical connection therebetween with reliability.

## Claims

1. An inspection probe for an electronic circuit board which is an assembly comprising:
(a) a base plate made from an electrically insulating plastic resin and having an opening;
(b1) a first group of electrodes (3) fixed and arranged on the base plate (1) in the vicinity of the periphery of the opening (4);
(b2) a second group of electrodes (3') fixed and arranged on the base plate in the vicinity of the outer periphery of the base plate, the first group of electrodes and the second group of electrodes being electrically connected to form an electric circuit;
(c) connecting lead wires (2) each bonded at one end to one of the first group of electrodes, the other end being extended downwardly through the opening in the base plate;
(d) an encapsulation (5) molded from an insulating elastomeric polymer having flexibility to embed the connecting lead wires as a whole, the downwardly extended end (7,8) of each of the connecting lead wires being exposed out of the encapsulation to face downwardly in such a fashion as to be capable of being contacted with one of the electrodes on an electronic circuit board under inspection; and
(e) a reinforcement (6) molded from a rigid material to cover the encapsulation.

2. The inspection probe for an electronic circuit board as claimed in claim 1 in which the base plate (14) has a stepped surface around the opening with stepped surfaces stepping down toward the opening and the first group electrodes are formed on the stepped areas of the base plate.

3. The inspection probe for an electronic circuit board as claimed in claim 1 in which the reinforcement has a view hole (16) penetrating therethrough and opening to the opening in the base plate.

4. The inspection probe for an electronic circuit board as claimed in claim 1 in which the reinforcement has a plurality of heat-dissipating fins (17A).

5. A method for inspection of an electronic circuit board by mounting the inspection probe defined in claim 1 thereon which comprises the steps of:
i) bringing into contact the exposed end of each of the connecting lead wires with one of the electrodes of a first group on the electronic circuit board under inspection;
ii) electrically connecting each of a second group of electrodes on the electronic circuit board under inspection with one of the electrodes on a first base board of an inspection instrument either directly or with intervention of an elastic connector; and
iii) electrically connecting each of the electrodes on a second base board of the inspection instrument, which are in connection by wiring with the first base board of the inspection instrument, with one of the second group of electrodes of the inspection probe with intervention of an elastic connector.

6. The method for inspection of an electronic circuit board by mounting the inspection probe thereon as claimed in claim 5 in which the electrodes on a first base board of an inspection instrument are provided with a plurality of pogo pins (32) which come into contact with the second group electrodes on the electronic circuit board to establish electrical connection therebetween.

## Patentansprüche

1. Prüfsonde für eine elektronische Leiterplatte, die eine Baugruppe ist, mit:
(a) einer Basisplatte, die aus einem elektrisch isolierenden Kunststoffharz hergestellt ist und eine Öffnung aufweist;
(b1) einer ersten Gruppe von Elektroden (3), die an der Basisplatte (1) in der Nähe des Umfangs der Öffnung (4) befestigt und angeordnet sind;
(b2) einer zweiten Gruppe von Elektroden (3'), die an der Basisplatte in der Nähe des äußeren Umfangs der Basisplatte befestigt und angeordnet sind, wobei die erste Gruppe von Elektroden und die zweite Gruppe von Elektroden elektrisch verbunden sind, um eine elektrische Schaltung zu bilden;
(c) verbindende Anschlussdrähte (2), die jeweils an einem Ende mit einer der ersten Gruppe von Elektroden gebondet sind, wobei sich das andere Ende nach unten durch die Öffnung in der Basisplatte erstreckt;
(d) einer Verkapselung (5), die aus einem isolierenden elastomerischen Polymer geformt ist, mit einer Flexibilität, um die verbindenden Anschlussdrähte als ganzes einzubetten, wobei das sich nach unten erstreckende Ende (7, 8) jeder der verbindenden Anschlussdrähte von der Verkapselung freigelegt ist, um auf eine solche Art und Weise nach unten zu liegen, um im Stande zu sein, mit einer der Elektroden auf einer unter Prüfung befindlichen elektronischen Leiterplatte kontaktiert zu werden; und
(e) einer Verstärkung (6), die aus einem starren Material geformt ist, um die Verkapselung abzudecken.

2. Prüfsonde für eine elektronische Leiterplatte gemäß Anspruch 1, bei der die Basisplatte (14) eine abgestufte Oberfläche um die Öffnung mit abgestuften Oberflächen aufweist, die sich nach unten zu der Öffnung hin abstufen, und die erste Gruppe von Elektroden an den abgestuften Bereichen der Basisplatte ausgebildet sind.

3. Prüfprobe für eine elektronische Leiterplatte gemäß Anspruch 1, bei der die Verstärkung ein Sichtloch (16) aufweist, das dahindurch dringt und sich zu der Öffnung in der Basisplatte öffnet.

4. Prüfprobe für eine elektronische Leiterplatte gemäß Anspruch 1, bei der die Verstärkung einer Mehrzahl von wärmedissipierenden Rippen (17A) aufweist.

5. Verfahren zum Prüfen einer elektronischen Leiterplatte durch Anbringen der in Anspruch 1 definierten Prüfprobe darauf, mit folgenden Schritten:
i) in Berührung bringen des freigelegten Endes jeder der verbindenden Anschlussdrähte mit einer der Elektroden einer ersten Gruppe auf der unter Prüfung befindlichen elektronischen Leiterplatte;
ii) elektrisches Verbinden jeder einer zweiten Gruppe von Elektroden auf der unter Prüfung befindlichen elektronischen Leiterplatte mit einer der Elektroden auf einer ersten Basisplatte eines Prüfgerätes entweder direkt oder mit einem dazwischenliegenden elastischen Verbinder; und
iii) elektrisches Verbinden jeder der Elektroden auf einer zweiten Leiterplatte des Prüfgerätes, die durch Verdrahtung mit der ersten Basisplatte des Prüfgerätes in Verbindung sind, mit einer der zweiten Gruppe von Elektroden der Prüfprobe mit einem dazwischenliegenden elastischen Verbinder.

6. Verfahren zum Prüfen einer elektronischen Leiterplatte durch Anbringen der Prüfprobe darauf gemäß Anspruch 5, bei dem die Elektroden einer ersten Basisplatte eines Prüfgeräts mit einer Mehrzahl von Pogo-Stiften (32) versehen sind, die mit der zweiten Gruppe von Elektroden auf der elektronischen Leiterplatte in Berührung kommen, um eine elektrische Verbindung dazwischen einzurichten.

## Revendications

1. Sonde de contrôle pour une carte de circuit électronique qui est un assemblage comprenant :
(a) une plaque de base faite d'une résine en plastique isolante électriquement et ayant une ouverture ;
(b1) un premier groupe d'électrodes (3) fixé et disposé sur la plaque de base (1) au voisinage de la périphérie de l'ouverture (4) ;
(b2) un second groupe d'électrodes (3') fixé et disposé sur la plaque de base au voisinage de la périphérie externe de la plaque de base, le premier groupe d'électrodes et le second groupe d'électrodes étant raccordés électriquement pour former un circuit électrique ;
(c) des fils de sortie de connexion (2) chacun soudé à une extrémité à une du premier groupe d'électrodes, l'autre étant étendue vers le bas à travers l'ouverture dans la plaque de base ;
(d) une encapsulation (5) moulée à partir d'un polymère élastomère isolant ayant une souplesse pour incorporer les fils conducteurs de raccordement dans leur ensemble, les extrémités étendues vers le bas (7,8) de chacun des fils conducteurs de raccordement étant exposées en dehors de l'encapsulation pour être en regard vers le bas de manière à être capable à être en contact avec une des électrodes sur une carte de circuit électronique sous contrôle ; et
(e) le renforcement (6) moulé à partir d'un matériau rigide pour couvrir l'encapsulation.

2. Sonde de contrôle pour une carte de circuit électronique selon la revendication 1, dans laquelle la plaque de base (14) possède une surface étagée autour de l'ouverture avec des surfaces étagées vers le bas l'ouverture et le premier groupe d'électrodes sont formés sur les zones étagées de la plaque de base.

3. Sonde de contrôle pour une carte de circuit électronique selon la revendication 1, dans laquelle le renforcement possède un trou d'observation (16) pénétrant à travers celle-ci et une ouverture pour l'ouverture dans la plaque de base.

4. Sonde de contrôle pour une carte de circuit électronique selon la revendication 1, dans laquelle le renforcement possède une pluralité d'ailettes de dissipation thermique (17A).

5. Procédé de contrôle d'une carte de circuit électronique en montant la sonde de contrôle définie selon la revendication 1 sur celle-ci qui comprend les étapes de :
i) mise en contact de l'extrémité exposée de chacun des fils conducteurs de raccordement avec une des électrodes d'un premier groupe sur la carte de circuit électronique en cours de contrôle ;
ii) raccordement électrique de chacun du second groupe d'électrodes sur la carte de circuit électronique en cours de contrôle avec une des électrodes sur la première carte de base d'un instrument de contrôle soit directement soit avec l'intervention d'un connecteur souple ; et
iii) raccordement électrique de chacune des électrodes sur une seconde carte de base de l'instrument de contrôle, qui sont en liaison par câblage avec la première carte de base de l'instrument de contrôle, avec une du second groupe d'électrodes de la sonde de contrôle avec l'intervention d'un connecteur souple.

6. Procédé pour le contrôle d'une carte de circuit électronique par le montage d'une sonde de contrôle sur celle-ci selon la revendication 5, dans lequel les électrodes sur la première carte de base d'un instrument de contrôle sont pourvues d'une pluralité de broches pogo (32) qui viennent en contact avec le second groupe d'électrodes sur la carte de circuit électronique pour établir une connexion électrique entre elles.
